# EUROPEAN PATENT APPLICATION

(11) **EP 1 030 352 A2**
(43) Date of publication of application: **23.08.2000**
(21) Application number: 00301156.6
(22) Date of filing: 15.02.2000
(51) Int. Cl.: H01L 21/205

(54) **Method and apparatus for forming materials layers from atomic gases**

(30) Priority: 17.02.1999 US 251701
(71) Applicant: Applied Materials, Inc., Santa Clara, California 95054 (US)
(72) Inventor: Yieh Ellie, California 94030 (US); Xia Li-Qun, San Jose CA 95111 (US)
(74) Representative: Allard, Susan Joyce

(57) **Abstract**

A method of forming material layers on a substrate using atomic gas is provided. A substrate is heated to an elevated temperature and is exposed to an atomic gas. The atomic gas reacts at a surface of the substrate to form a material layer thereon. The source of atomic gas preferably comprises a molecular gas source operatively coupled to a remote microwave plasma system that dissociates the molecular gas into highly reactive atomic gas. Gate quality silicon dioxide, oxynitride and silicon nitride may be formed by the dissociation of O₂, O₂ and N₂ or NH₃, and N₂ or NH₃, respectively, at reduced temperatures (e.g., about 600-650°C). Because of the reduced formation temperatures, a uniform heating mechanism such as a ceramic heater may be employed for substrate heating so that a more uniformly-thick material layer results. To reduce recombination of gas atoms into molecular gas, the path length between the atomic gas source and the substrate is reduced, or an inert gas may be used to dilute the atomic gas so as to spatially separate gas atoms. A portion of the path between the atomic gas source and the substrate also may be coated with a protective coating to prevent gas atom recombination.

## Description

The present invention relates to semiconductor device processing and more specifically to forming semiconductor device material layers from atomic gasses.

The drive for higher performance, higher density electronics has lead to continual scaling of the lateral dimensions of metal-oxide-semiconductor (MOS) devices. As lateral device dimensions are reduced, a MOS device's gate dielectric thickness (e.g., silicon dioxide thickness) also must be reduced to maintain sufficient charge storage capacity for proper operation of the MOS device.

Modern lateral device dimension requirements have forced gate dielectrics into the sub-100 angstrom regime without a proportional decrease in drive voltage. The combination of thinner gate dielectric layers with the same or similar drive voltages has lead to increased device electric fields for each successive MOS device generation. Accordingly, hot-carrier damage associated with these increased electric fields and dielectric breakdown strength have become major concerns with regard to further scaling of MOS devices. Additionally, reduced MOS device dimensionality has led to extensive use of fabrication techniques such as e-beam lithography and reactive ion etching which employ energetic particles and produce ionizing radiation that can damage conventional furnace grown silicon dioxide (SiO₂) gate dielectrics. Further, thin silicon dioxide is a poor barrier against boron diffusion, making its use with boron doped p+ polycrystalline silicon gate electrodes problematic.

Silicon dioxide gate dielectrics conventionally are furnace grown at temperatures in excess of 900°C. At such elevated temperatures, silicon dioxide film growth exceeds the thermal budget of future generation MOS processes (e.g., 650°C). Further, film thickness uniformity variations (due to the non-uniform wafer heating and oxygen flow inherent in oxidation furnaces) are unacceptably high for future generation MOS devices (e.g., sub-50 angstrom oxide devices). Accordingly even if the hot-carrier damage, dielectric breakdown strength and diffusion barrier properties of silicon dioxide can be compensated for, the growth of thin silicon dioxide layers of repeatable thickness and sufficient thickness uniformity remains a challenge.

A potential alternative to the use of "pure" silicon dioxide as a gate dielectric is the use of "nitrided oxides" or "oxynitrides" such as ammonia or nitrous-oxide annealed silicon dioxide. An oxide/nitride stack comprising a thin, silicon dioxide layer grown on the silicon wafer (so as to form a high quality Si/SiO₂ interface), and a silicon nitride layer deposited thereon also may be used.

An oxynitride incorporates a small amount (e.g., 1-5 atomic percent) of nitrogen at the Si/SiO₂ interface via a post-growth annealing step in a nitrogen-rich environment (e.g., NH₃ or N₂O). The interfacial nitrogen improves the hot-carrier and radiation damage resistance of oxynitrides, and enhances the oxynitride's barrier diffusion properties. However, oxynitrides typically are furnace grown silicon dioxide subjected to an additional annealing step (or are directly formed by furnace growth in nitrous oxide) and therefore suffer from the same thickness uniformity problems as pure silicon dioxide. Ammonia annealing also generates hydrogen-induced electron traps within the oxynitride that deleteriously affect device performance.

Another potential alternative to silicon dioxide is silicon nitride. Silicon nitride has a higher dielectric constant than silicon dioxide so that a thinner layer of silicon nitride has the same charge storage capacity as a much thicker silicon dioxide layer without dielectric breakdown. Silicon nitride gate dielectrics, therefore, are more scaleable than silicon dioxide gate dielectrics (e.g., for future generation MOS devices). Further, silicon nitride exhibits superior long-term reliability properties and superior moisture and dopant diffusion barrier properties than either silicon dioxide or oxynitride. Silicon nitride, however, also suffers from hydrogen-induced electron traps that render the commercial use of silicon nitride gate dielectrics impractical, despite decades of research.

Conventional silicon nitride is deposited, not grown, on a silicon substrate by a furnace-based low pressure chemical vapor deposition (LPCVD) process. Specifically, ammonia (NH₃) and silicon tetrachloride (SiCl₄) are reacted within a furnace at about 900°C to form silicon nitride (Si₃N₄) and hydrochloric acid (HCl) on a semiconductor wafer. During the deposition process ammonia liberates hydrogen that generates electron traps within the deposited silicon nitride film. The electron traps severely impact the electrical characteristics of the deposited silicon nitride film and render the silicon nitride film ineffective as a gate dielectric.

LPCVD silicon nitride processes also employ environmentally unfriendly gasses (e.g., NH₃, SiCl₄) that are incompatible with the "green" initiatives of many semiconductor manufactures. Further, LPCVD silicon nitride deposition, like conventional silicon dioxide and oxynitride growth, is furnace-based and suffers from similar thickness uniformity problems. Another disadvantage of conventional gate dielectrics is the thermal budget of the processes used to form the gate dielectrics. For example, conventionally the growth of silicon dioxide and oxynitride, and the deposition of silicon nitride by LPCVD are performed at elevated temperatures (e.g., greater than 900°C) that exceed the thermal budget of future generation MOS processes (e.g., 650°C etc.).

Accordingly, a need exists for an improved gate dielectric that does not suffer from thickness non-uniformities, that does not exceed the thermal budget constraints of future generation MOS processes, and that preferably has superior reliability and barrier diffusion properties than silicon dioxide.

To address the needs of the prior art, a novel method of forming material layers on a substrate (e.g., a semiconductor wafer) using atomic gasses is provided. Specifically, a substrate is heated to an elevated temperature (e.g., 600-650°C) while being exposed to an atomic gas. The atomic gas reacts at a surface of the substrate to form a material layer thereon.

The source of atomic gas preferably comprises a source of molecular gas (e.g., O₂, N₂, NH₃, etc.) operatively coupled (i.e., coupled so as to operate) to a remote microwave plasma source that dissociates the molecular gas into highly reactive atomic gas. Because of the high chemical potential of the atomic gas, the atomic gas readily reacts at heated substrate surfaces to form material layers thereon, even at reduced temperatures.

The novel material layer formation method is particularly well suited for growing silicon dioxide (e.g., via the dissociation of O₂), oxynitride (e.g., via the dissociation of O₂ and N₂ or NH₃) and silicon nitride (via the dissociation of N₂ or NH₃) all at temperatures (e.g., about 600-650°C) lower than conventional furnace-based formation method temperatures (e.g., above 900°C). Deposited silicon dioxide films also may be formed with atomic oxygen and tetraethyl orthosilicate (TEOS) where currently ozone is adopted commercially as the oxidant.

A significant advantage of the present invention is that gate quality silicon nitride material layers (e.g., having few, if any, hydrogen-induced election traps) may be grown with atomic nitrogen (e.g., via the dissociation of molecular nitrogen) at a lower thermal budget. Further, because of the low gate dielectric formation temperatures employed, a highly uniform heating mechanism such as a ceramic heater may be used during material layer formation. Material layer thickness uniformity thereby is enhanced over furnace-based formation methods. Accordingly, an improved gate dielectric having reduced thickness non-uniformities and superior reliability and barrier diffusion properties can be formed within the thermal budget constraints of future generation MOS processes.

Because the employed atomic gasses prefer a more stable molecular form, several techniques are provided to reduce the recombination of gas atoms into gas molecules en route from the remote microwave plasma source to the substrate (e.g., to enhance growth rate, to provide more precise control over material layer stochiometry, etc.). For example, the path length between the atomic gas source and the substrate preferably is minimized, and the molecular gas source and/or the formed atomic gas may be diluted with an inert gas (e.g., argon) that separates gas atoms so as to prevent their recombination. All or a portion of the path between the atomic gas source and the substrate also may be coated with a material that reduces the number of available atomic gas recombination sites (i.e., a protective coating).

Other objects, features and advantages of the present invention will become more fully apparent from the following detailed description of the preferred embodiments, the appended claims and the accompanying drawings, provided by way of example.
FIG. 1 is a side elevational view of a semiconductor wafer processing system configured for atomic gas material layer formation in accordance with the present invention; and
FIG. 2 is a top plan view of an automated tool for fabricating semiconductor devices that employs the semiconductor wafer processing system of FIG. 1.

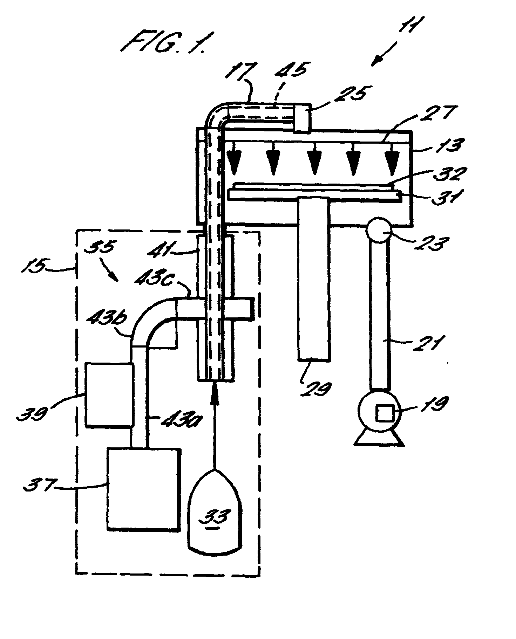

FIG. 1 is a side elevational view of a semiconductor wafer processing system 11 ("processing system 11") configured for atomic gas material layer formation in accordance with the present invention. The processing system 11 comprises a processing chamber 13 operatively coupled to an atomic gas source 15 via an input pipe 17 and to a pump 19 via a foreline 21 and a throttle valve 23. A suitable processing system is the GIGAFILL™ processing system manufactured by Applied Materials, Inc. and described in commonly assigned U.S. patent application Serial No. 08/748,883, filed Nov. 13, 1996, which is hereby incorporated by reference herein in its entirety.

The processing chamber 13 comprises an inlet 25 operatively coupled to the input pipe 17 for receiving atomic gas from the atomic gas source 15, and a gas distribution plate 27 operatively coupled to the inlet 25 for uniformly distributing atomic gas along the surface of a semiconductor wafer disposed within the processing chamber 13. The processing chamber 13 further comprises a wafer support 29 located below the gas distribution plate 27 and having a heating mechanism (e.g., a ceramic heater 31) mounted thereto for supporting and heating a semiconductor wafer during processing within the processing chamber 13. The ceramic heater 31 has a maximum heating temperature of approximately 800°C and preferably comprises a material such as aluminum nitride. Other heating mechanisms comprising different materials and different temperature maxima may be employed.

The atomic gas source 15 comprises a molecular gas source 33 operatively coupled to a remote microwave plasma system 35. The molecular gas source 33 preferably comprises a source gas such as O₂, N₂ or NH₃, depending on the material layer to be formed. The source gas may be diluted with an inert gas such as argon (as described below).

The remote microwave plasma system 35 comprises a magnetron head 37 operatively coupled to a tuner 39, and a microwave applicator 41 operatively coupled to the tuner 39, to the input pipe 17 and to the molecular gas source 33. Specifically, the magnetron head 37, the tuner 39 and the microwave applicator 41 are operatively coupled via a waveguide system 43a-c that guides microwave energy generated by the magnetron head 37 to the microwave applicator 41.

The magnetron head 37 generates a pulsed or a continuous wave microwave output centered at approximately 2.5 GHZ with a power between about 0-3000 Watts. Any conventional magnetron head may be employed as the magnetron head 37.

Microwaves generated by the magnetron head 37 are output to the waveguide system 43a-c and travel through a first waveguide section 43a, a second waveguide section 43b and a third waveguide section 43c to the microwave applicator 41. The tuner 39 is operatively coupled to the first waveguide section 43a and comprises conventional microwave tuning elements (e.g., stub tuners, etc.) that allow the remote microwave plasma system 35 to match the characteristic impedance of the third waveguide section 43c (e.g., so as to reduce reflection of microwave power back to the magnetron head 37). Microwave power thereby is efficiently delivered to the microwave applicator 41.

In operation, to grow a silicon nitride layer on a silicon semiconductor wafer 32 employing the processing system 11, the semiconductor wafer 32 is loaded into the processing chamber 13, placed on the wafer support 29 and the processing chamber 13 is evacuated via the pump 19. The base pressure of the processing chamber 13 is set by adjusting the throttle valve 23. A base pressure of about 0.4 Torr is presently preferred although other chamber pressures may be employed.

During evacuation of the processing chamber 13, power is applied to the ceramic heater 31 to raise the temperature of the semiconductor wafer 32 to the growth temperature. As described further below, due to the high chemical potential of atomic nitrogen, silicon nitride growth occurs at significantly lower temperatures than the temperatures required for silicon nitride formation via LPCVD. Accordingly, silicon nitride growth may be performed below 800°C and preferably is performed in the range of about 600-650°C. The ceramic heater 31, therefore, preferably is heated to about 600-650°C.

After the semiconductor wafer 32 has reached the growth temperature and after the processing chamber 13 has stabilized at the desired base pressure, the magnetron head 37 is turned on so as to apply microwave power to the microwave applicator 41, and molecular gas is flowed from the molecular gas source 33 to the microwave applicator 41. The microwave power level applied to the microwave applicator 41 is the power level required to generate a sufficient concentration of atomic nitrogen within the processing chamber 13 to affect silicon nitride growth. The appropriate power level depends on many factors (e.g., the concentration of atomic nitrogen within the microwave applicator 41, the distance between the microwave applicator 41 and the semiconductor wafer 32, the material encountered by the atomic nitrogen as it travels from the microwave applicator 41 to the semiconductor wafer 32, etc.) as described further below. A power level of between 1000-3000 watts therefore is preferred.

The preferred molecular gas for silicon nitride growth is molecular nitrogen (N₂). Ammonia (NH₃) also may be employed. Ammonia, however, leads to hydrogen-induced electron trap formation during silicon nitride growth and is not as environmentally friendly as N₂.

Molecular nitrogen from the molecular gas source 33 travels into the microwave applicator 41 and is dissociated into atomic nitrogen by the microwave energy applied to the microwave applicator 41 by the magnetron head 37. Specifically, a window (now shown) in the microwave applicator 41 allows microwaves from the third waveguide section 43c to pass through the outer portion of the microwave applicator 41 and to interact with molecular nitrogen therein. A plasma ignition system (e.g., an ultra-violet light) may be employed for the initial ionization of a nitrogen plasma, and the microwave energy then sustains the plasma. Only a small portion of the nitrogen is ionized, and the plasma may comprise other ionized species if a diluting gas is present (such as argon ions if argon is employed as a diluting gas). The microwave applicator 41 thus creates a flow of atomic nitrogen that travels from the microwave applicator 41 to the input pipe 17 of the processing chamber 13.

Nitrogen gas atoms prefer a more stable molecular form (N₂). As such, a nitrogen atom will readily recombine with another nitrogen atom to form N₂ if the two nitrogen atoms are spacially proximate. A difficult challenge, therefore, is to transport a sufficient and a controlled amount of atomic nitrogen to the semiconductor wafer 32 (on which a silicon nitride layer is to be grown) before the atomic nitrogen recombines to form molecular nitrogen (e.g., to enhance the growth rate of silicon nitride, to provide more control over silicon nitride stochiometry, etc.).

To reduce recombination of atomic nitrogen, the path length between the microwave applicator 41 and the semiconductor wafer 32 can be minimized by connecting the microwave applicator 41 as close as possible to the processing chamber 13 (e.g., providing either the processing chamber 13 or the microwave applicator 41 with a connector for mounting the microwave applicator 41 directly adjacent the processing chamber 13). The molecular gas source 33 also may be diluted with an inert gas (e.g., argon) that separates nitrogen gas atoms generated in the microwave applicator 41 as the nitrogen gas atoms travel to the semiconductor wafer 32. Similarly, a separate inert gas source may be coupled to the microwave applicator 41 and used to supply an inert gas that separates nitrogen gas atoms generated in the microwave applicator 41. Additionally, a portion of or all of the path between the microwave applicator 41 and the semiconductor wafer 32 may be coated with a protective coating that prevents nitrogen gas atoms from adhering thereto and serving as recombination sites for subsequent nitrogen gas atoms. In FIG. 1, the entire path between the inlet 25 and the microwave applicator 41 (including the microwave applicator 41) is coated with a protective coating 45 (e.g., aluminum nitride) that resists nitrogen gas atom adhesion. The inlet 25, the processing chamber 13 and the gas distribution plate 27 also may be coated with the protective coating 45 to further enhance the concentration of atomic nitrogen that reaches the semiconductor wafer 32.

Once the atomic nitrogen reaches the top surface of the heated semiconductor wafer 32, due to the high chemical potential of atomic nitrogen, the atomic nitrogen readily reacts with the silicon wafer 32 to form a silicon nitride material layer thereon (not shown).

A significant advantage of the present invention is that gate quality silicon nitride may be grown on the semiconductor wafer 32 (via atomic nitrogen formed from the dissociation of molecular nitrogen) without generating hydrogen-induced electron traps within the silicon nitride. Further, because of the low growth temperatures (and the low thermal budget associated therewith that prevents undesirable dopant diffusion), the ceramic heater 31, with its enhanced temperature-uniformity, may be used during silicon nitride growth. Silicon nitride thickness uniformity thereby is enhanced over furnace-based formation methods. Additionally, no complicated and environmentally unfriendly nitrogen or silicon precursors are required to affect silicon nitride layer formation.

In addition to silicon nitride, the processing system 11 may be used to grow gate quality silicon dioxide via the dissociation of molecular oxygen within the microwave applicator 41. For silicon dioxide growth, the molecular gas source 33 comprises a source of molecular oxygen that supplies molecular oxygen to the microwave applicator 41. The microwave applicator 41 generates an oxygen plasma, and a stream of atomic oxygen flows to the processing chamber 13 via the input pipe 17. Similar methods for reducing atomic oxygen recombination preferably are employed (e.g., a reduced path length between the microwave applicator 41 and the semiconductor wafer 32, a protective coating 45, dilution of the molecular oxygen supply with an inert gas, etc.).

The atomic oxygen reaches the top surface of the heated (e.g., about 600-650°C) semiconductor wafer 32 and due to the high chemical potential of atomic oxygen, readily reacts with the silicon wafer 32 to form silicon dioxide. The temperature uniformity of the ceramic heater 31 enhances the thickness uniformity of the heater-based silicon dioxide over furnace-based silicon dioxide. Improved thickness uniformity silicon dioxide, therefore, may be grown at substantially reduced temperatures.

In addition to silicon nitride and silicon dioxide, the processing system 11 may be used to grow gate quality oxynitrides via the dissociation of both molecular oxygen and molecular nitrogen within the microwave applicator 41. In such applications the molecular gas source 33 comprises both a source of molecular oxygen and a source of molecular nitrogen (or may comprise a source of nitrous oxide that may be directly dissociated into nitrogen and oxygen), and the microwave applicator 41 generates an oxygen and a nitrogen based plasma. A stream of atomic nitrogen and a stream of atomic oxygen thus simultaneously flow to the processing chamber 13 via the input pipe 17. Nitrogen recombination and oxygen recombination preferably are limited as described above.

The atomic nitrogen and the atomic oxygen reach the top surface of the heated (e.g., about 600-650°C) semiconductor wafer 32 and due to the high chemical potential of both atomic nitrogen and atomic oxygen, a silicon dioxide layer having a concentration of nitrogen at the Si/SiO₂ interface is readily formed. The concentration of nitrogen at the Si/SiO₂ interface is controlled by the relative amounts of atomic nitrogen and atomic oxygen present during silicon dioxide growth. The temperature uniformity of the ceramic heater 31 enhances the thickness uniformity of the heater-based oxynitride as compared to a furnace-based oxynitride. Improved thickness uniformity oxynitride, therefore, may be grown at substantially reduced temperatures.

Another significant advantage of the present invention is that each semiconductor wafer is exposed to identical processing conditions (e.g., each wafer may be identically cleaned with a fluorine species generated within the microwave applicator 41) prior to material layer formation (e.g., silicon nitride, silicon dioxide, oxynitride, etc.). See, for example, U.S. Patent No. 5,812,403 which is hereby incorporated by reference herein in its entirety. Furnace-based formation processes requires an ex-situ wet cleaning prior to wafer loading into the furnace so that each wafer may be exposed to different processing conditions or to the same processing conditions for a different amount of time prior to material layer formation within the furnace. Furnace-based formation processes also suffer from temperature and gas distribution non-uniformities as previously described. Thus, process uniformity is enhanced via the present invention.

The processing system 11 also may be used to improve the efficiency of silicon dioxide deposition (e.g., chemical vapor deposition (CVD)) by employing atomic oxygen and TEOS instead of ozone (O₃) and TEOS during silicon dioxide layer deposition. The atomic oxygen is generated via the microwave applicator 41 as previously described. Because the atomic oxygen can directly react with TEOS at the surface of the semiconductor wafer 32 (e.g., without requiring the intermediate step of the dissociation of O₃ into atomic oxygen at the heated semiconductor wafer 32), the deposition rate of silicon dioxide is enhanced without increasing deposition temperature.

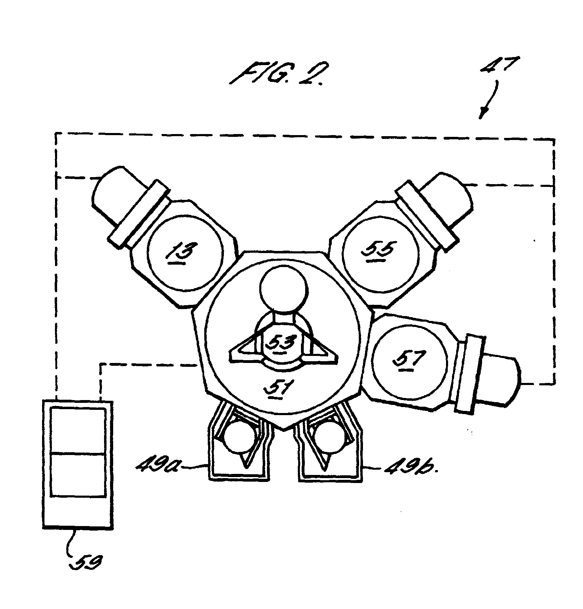

FIG. 2 is a top plan view of an automated tool 47 for fabricating semiconductor devices. The tool 47 comprises a pair of load locks 49a, 49b, and a wafer handler chamber 51 containing a wafer handler 53. The wafer handler chamber 51 and the wafer handler 53 are operatively coupled to a plurality of processing chambers 55, 57. Most importantly, the wafer handler chamber 51 and the wafer handler 53 are operatively coupled to the processing chamber 13 of the processing system 11 of FIG. 1. The entire tool 47 is controlled by a controller 59 having a program therein which controls semiconductor wafer transfer among the load locks 49a, 49b, and the processing chambers 55, 57 and 13, and which controls processing therein.

The controller 59 contains a program for performing silicon nitride, silicon dioxide or oxynitride growth or silicon dioxide deposition within the processing chamber 13 in accordance with the processing parameters described with reference to FIG. 1. In particular the program controls the flow rate of molecular gas from the molecular gas source 33 to the microwave applicator 41, the microwave power level applied to the microwave applicator 41, the base pressure of the processing chamber 13, the temperature of the ceramic heater 31, and the material layer formation time, as well as other relevant processing parameters. Because gate dielectric growth can be performed on a semiconductor wafer without removing the semiconductor wafer from the tool 47's vacuum environment, the potential for wafer contamination is reduced and device yield is increased.

The foregoing description discloses only the preferred embodiments of the invention, modifications of the above disclosed apparatus and method which fall within the scope of the invention will be readily apparent to those of ordinary skill in the art. For instance, other molecular gas sources may be employed for the formation of silicon dioxide, silicon nitride, oxynitride or other material layers. Further the exact processing conditions (e.g., microwave power, chamber base pressure, molecular gas flow rate, processing temperature, etc.) depend on many factors (e.g., the process gasses employed, whether the process gasses are diluted, the distance between the microwave applicator 41 and the semiconductor wafer 32, the type of protective coating 45 employed, the target thickness, etch-properties, stochiometry, density, etc., for the material layer to be formed, the thermal budget constraints, etc.) and a person of ordinary skill in the art will understand how to vary processing conditions to compensate for these and other factors so as to affect formation of a desired material layer via the processing system 11.

Accordingly, while the present invention has been disclosed in connection with the preferred embodiments thereof, it should be understood that other embodiments may fall within the spirit and scope of the invention, as defined by the following claims.

## Claims

1. A method of forming a material layer on a substrate, which method comprises:
providing a substrate on which a material layer is to be deposited;
elevating the temperature of the substrate; providing a source of an atomic gas; transferring atomic gas from the source of the atomic gas to the elevated temperature substrate; and
forming a material layer on the substrate with the atomic gas.

2. A method as claimed in claim 1, wherein providing a substrate comprises providing a semiconductor wafer.

3. A method as claimed in claim 1 or claim 2, wherein elevating the temperature of the substrate comprises elevating the temperature of the substrate to less than about 650°C.

4. A method as claimed in any one of the preceding claims, wherein elevating the temperature of the substrate comprises providing a ceramic heater, placing the substrate on the ceramic heater and heating the substrate with the ceramic heater.

5. A method as claimed in any one of the preceding claims, wherein providing a source of atomic gas comprises:
providing a source of molecular gas; and
providing a microwave plasma system for operatively coupling to the source of molecular gas and for dissociating the molecular gas to form a source of atomic gas.

6. A method as claimed in claim 5, wherein the source of molecular gas comprises a source of molecular nitrogen and wherein forming a material layer on the substrate with the atomic gas comprises growing a silicon nitride layer on the substrate with atomic nitrogen.

7. A method as claimed in any one of the preceding claims, wherein elevating the temperature of the substrate comprises elevating the temperature of the substrate to from about 600 to about 650°C.

8. A method as claimed in claim 5, wherein the source of molecular gas comprises a source of ammonia and wherein forming a material layer on the substrate with the atomic gas comprises growing a silicon nitride layer on the substrate with atomic nitrogen.

9. A method as claimed in claim 5, wherein the source of molecular gas comprises a source of molecular oxygen and wherein forming a material layer on the substrate with the atomic gas comprises growing a silicon dioxide layer with atomic oxygen.

10. A method as claimed in claim 5, wherein the source of molecular gas comprises a source of molecular oxygen and a source of molecular nitrogen and wherein forming a material layer on the substrate with the atomic gas comprises growing an oxynitride layer with atomic oxygen and atomic nitrogen.

11. A method as claimed in claim 5, wherein the source of molecular gas comprises a source of oxygen and wherein forming a material layer on the substrate with the atomic gas comprises depositing a silicon dioxide layer with atomic oxygen and TEOS via chemical vapor deposition.

12. A method as claimed in any one of the preceding claims, further comprising reducing the formation of molecular gas from atomic gas during the step of transferring atomic gas from the source of the atomic gas to the elevated temperature substrate.

13. A method as claimed in claim 12, wherein reducing the formation of molecular gas from atomic gas comprises reducing the path length between the atomic gas source and the substrate.

14. A method as claimed in claim 12, wherein reducing the formation of molecular gas from atomic gas comprises coating at least a portion of the path between the atomic gas source and the substrate with a protective coating.

15. A method as claimed in claim 12, wherein reducing the formation of molecular gas from atomic gas comprises diluting the source of atomic gas with an inert gas.

16. A method as claimed in any one of the preceding claims, wherein the thus formed material layer and substrate form at least a part of a semiconductor device.

17. An apparatus for forming a material layer on a substrate, which apparatus comprises:
a processing chamber;
a substrate support operatively coupled to the processing chamber for supporting a substrate on which a material layer is to be formed;
a heating mechanism operatively coupled to the substrate support for heating a substrate supported by the substrate support;
an atomic gas generator operatively coupled to the processing chamber for generating and supplying atomic gas to the processing chamber; and
a recombination reduction mechanism operatively coupled to the atomic gas generator for reducing the formation of molecular gas from the atomic gas generated by the atomic gas generator.

18. An apparatus as claimed in claim 17, wherein the processing chamber comprises a semiconductor wafer processing chamber.

19. An apparatus as claimed in claim 17 or claim 18, wherein the heating mechanism comprises a ceramic heater.

20. An apparatus as claimed in any one of claims 17 to 19, wherein the atomic gas generator comprises a microwave plasma system for coupling to a source of molecular gas and for dissociating the molecular gas so as to generate atomic gas.

21. An apparatus as claimed in claim 20, wherein the atomic gas generator comprises a microwave plasma system for coupling to a source of molecular nitrogen and/or molecular oxygen.

22. An apparatus as claimed in any one of claims 17 to 21, wherein the recombination reduction mechanism comprises a connector configured to reduce the distance between the substrate support and the atomic gas generator.

23. An apparatus as claimed in any one of claims 17 to 21, wherein the recombination reduction mechanism comprises a protective coating for lining at least a portion of the path between the substrate support and the atomic gas generator.

24. An apparatus as claimed in any one of claims 17 to 21, wherein the recombination reduction mechanism comprises a source of inert gas for providing an inert gas that spatially separates atomic gas atoms generated by the atomic gas generator.

25. A semiconductor wafer processing tool comprising:
at least one load lock;
a wafer handler chamber operatively coupled to the at least one load lock;
the apparatus as defined in any one of claims 17 to 24 operatively coupled the wafer handler chamber; and
a wafer handler located within the wafer handler chamber and operatively coupled to both the at least one load lock and the apparatus as defined in any one of claims 17 to 24, the wafer handler for transferring a semiconductor wafer between the at least one load lock and the apparatus as defined in any one of claims 17 to 24.

26. A semiconductor wafer processing tool as claimed in claim 25, further comprising a controller operatively coupled tc the at least one load lock, the wafer handler chamber, the apparatus as defined in any one of claims 17 to 24 and the wafer handler, and programmed for:
loading a semiconductor wafer from the at least one load lock to the substrate support via the wafer handler;
elevating the temperature of the semiconductor wafer to a processing temperature via the heating mechanism;
generating atomic gas with the atomic gas generator;
supplying atomic gas to the processing chamber; and
forming a material layer on the semiconductor wafer with the atomic gas.
